# EUROPEAN PATENT APPLICATION

(11) **EP 1 533 851 A2**
(43) Date of publication of application: **25.05.2005**
(21) Application number: 04026711.4
(22) Date of filing: 10.11.2004
(51) Int. Cl.: H01L 33/00

(54) **Light-emitting diode and semiconductor light-emitting device**

(30) Priority: 20.11.2003 JP 2003390882
(71) Applicant: SUMITOMO ELECTRIC INDUSTRIES, Ltd, Osaka-shi, Osaka 541-0041 (JP)
(72) Inventor: Saito, Hirohisa, 1-1, Koyakita 1-chome Itami-shi Hyogo (JP); Hirose, Yoshiyuki, 1-1, Koyakita 1-chome Itami-shi Hyogo (JP); Nagai, Youichi, 1-1, Koyakita 1-chome Itami-shi Hyogo (JP); Kitabayashi, Hiroyuki, 1-1, Koyakita 1-chome Itami-shi Hyogo (JP); Ikeda, Ayako, 1-1, Koyakita 1-chome Itami-shi Hyogo (JP)
(74) Representative: Grünecker, Kinkeldey, Stockmair & Schwanhäusser Anwaltssozietät

(57) **Abstract**

A light-emitting diode (1) is furnished with a semiconductor laminate (6), optically reflective layers (17) and (19), an optically reflective film (25), and a phosphorescent plate (27). The laminate (6) is formed by an *n*-type cladding layer (9), an active layer (11), a *p*-type cladding layer (13), and a *p*-type contact layer (15), laminated in order onto a substrate (7). The optically reflective layers (17) and (19) are provided respectively on the *p*-type contact layer (15) and on the back side (7b) of the substrate (7). The optically reflective film (25) is provided on three side surfaces of the laminate (6). The phosphorescent plate (27) is mounted on a side face, among the side faces of the laminate (6), on which there is no optically reflective film (25). Blue light (*L1*) output from the active layer (11) is reflected at each of the optically reflective layers, and is gathered on the side face on which the phosphorescent plate (27) is provided. A portion of the blue light (*L1*) turns into yellow light (*L2*) in the phosphorescent plate (27), and white light derived from the blue light (*L1*) and yellow light (*L2*) is emitted.

## Description

### BACKGROUND OF THE INVENTION

### Field of the Invention

The present invention relates to light-emitting diodes and semiconductor light-emitting devices.

### Description of the Background Art

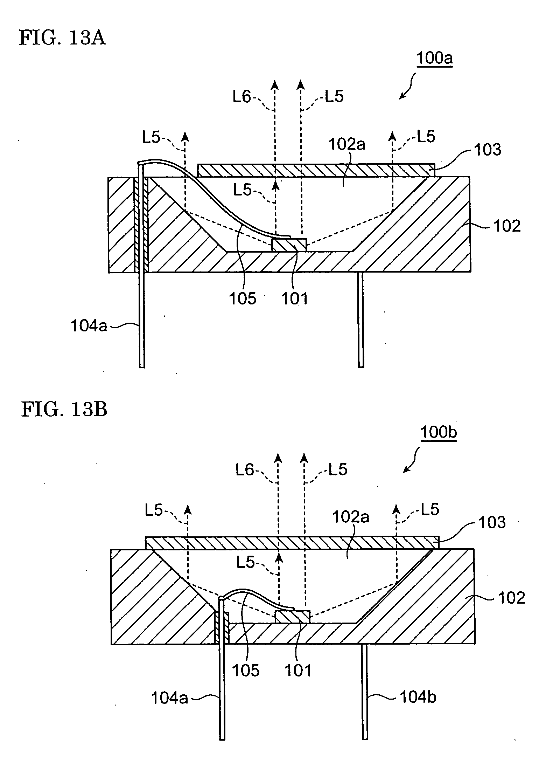

In recent years, the development of white light-emitting diodes (LEDs) into practical, working devices has flourished. White LEDs utilize short-wavelength LEDs-blue LEDs or ultraviolet LEDs-and phosphors that by the agency of light emitted from these LEDs fluoresce. Such white LEDs are utilized for example as the light source for liquid-crystal display backlights. Reference is made to Figs. 13A and 13B, which are sectional views illustrating examples of white LEDs. The white LED 100a depicted in Fig. 13A and the white LED 100b depicted in Fig. 13B are furnished with: a blue LED 101; a case 102 that accommodates the blue LED 101 within a cavity 102a; and, covering the cavity 102a, a phosphor 103 in solid form that receives blue light *L5* from the blue LED 101 and emits yellow light *L6.* White light is then realized by the color-mixing of the blue light *L5* from the blue LED 101 and the yellow light *L6* from the phosphor 103.

Apart from the configurations illustrated in Figs. 13A and 13B another example, which is disclosed in Japanese Unexamined Pat. App. Pub. Nos. H07-99345 and H10-93146, is a configuration in which a synthetic polymer incorporating a phosphorescent material covers a blue LED. A further example, disclosed in Japanese Unexamined Pat. App. Pub. Nos. H11-31845 and H11-46019, is a configuration in which a blue LED is coated with a phosphorescent material. In an additional example of a white LED configuration, disclosed in Japanese Unexamined Pat. App. Pub. No. H11-46015, a sputtering technique is employed to form a phosphorescent film onto a blue LED.

White LEDs of a configuration in which a blue LED is covered with a synthetic polymer containing a phosphorescent material, as is the case with the configuration disclosed in Pat. App. Pub. Nos. H07-99345 and H10-93146, suffer from problems such as follows. In mixing phosphorescent material into the synthetic polymer, in general a phosphorescent material in powdered form is employed, but the phosphor powder tends to clump within the synthetic polymer, making it difficult to obtain uniform (yellow light) luminescence. The white light is consequently not uniform, with mottled hues being produced instead.

In the configuration disclosed in Pat. App. Pub. Nos. H11-31845 and H11-46019, meanwhile, a phosphorescent material is spread onto a blue LED. Spreading the phosphorescent material on at a uniform thickness is, however, problematic; moreover, special equipment is required in order to apply the phosphorescent material, which is in powder or paste form, onto the LED. Finally, the method as in Pat. App. Pub. No. H11-46015, in which a phosphorescent film is formed using a sputtering technique, is impracticable in that too much time is required for forming the phosphorescent film to the necessary thickness, making productivity poor.

Taking the problems discussed above into consideration, it occurred to the present inventors that if the phosphorescent material is utilized in solid form its thickness can be readily adjusted to yield uniform luminescence and keep the white light from being blotchy. Nevertheless, in for example the configuration illustrated in Fig. 13A, in order to allow a wire 105 that joins a lead pin 104a with the blue LED 101 to pass through, the cavity 102a cannot be covered over entirely by means of the phosphor 103, which risks that lopsidedness will arise in the distribution of the yellow light *L6.* Likewise, in the configuration illustrated in Fig. 13B, although the phosphor 103 covers the cavity 102a completely the fact that the cavity 102a flares out from the blue LED 101 risks that a difference will arise between the luminous intensity of the blue light *L5* directly above the blue LED 101 and the intensity at the periphery. Consequently, with these configurations there is a likelihood that spottiness of hues will occur in the white light.

### SUMMARY OF THE INVENTION

An object of the present invention, which has been brought about taking the foregoing issues into consideration, is to make available light-emitting diodes and semiconductor light-emitting devices that enable an emission spectrum in which mottling is minimized to be achieved.

In order to resolve the problems discussed above, a first light-emitting diode according to the present invention is characterized in being furnished with: (1) a semiconductor laminate composed of nitride semiconductors, and having a first electroconductive semiconductor layer, a second electroconductive semiconductor layer, and an active layer, provided in between the first electroconductive semiconductor layer and the second electroconductive semiconductor layer, for emitting light in a first band of wavelengths; (2) a first optically reflective layer provided on a surface of the laminate opposite the surface of the first electroconductive semiconductor layer that faces onto the active layer; (3) a second optically reflective layer provided on a surface of the laminate opposite the surface of the second electroconductive semiconductor layer that faces onto the active layer; and (4) a phosphor, provided on a side face of the semiconductor laminate, for receiving light of the first wavelength band and emitting light in a second band of wavelengths.

In the above-described first light-emitting diode, the fact that the semiconductor laminate is sandwiched between the first and the second reflective layers means that the band #1 light output from the active layer is reflected at the first and second reflective layers and emitted through the side face of the laminate. Then inasmuch as a phosphor is provided on the side face of the semiconductor laminate, the phosphor is pumped by the band #1 light and emits band #2 light. An emission spectrum that is tuned depending on the band #1 light and the band #2 light is thus produced. Pursuant to a first light-emitting diode as set forth above, band #1 light from the active layer is gathered on the side face of the semiconductor laminate, and because the phosphor is meanwhile provided on the side face of the semiconductor laminate, by arbitrarily adjusting the thickness of the phosphor the intensity of the band #2 light can readily be made to conform with the intensity of the band #1 light. An emission spectrum in which unevenness of hue is minimized can accordingly be achieved.

The light-emitting diode further may be characterized in that the semiconductor laminate is additionally furnished, in between the first electroconductive semiconductor layer and the first optically reflective layer, with a substrate made from a GaN-based compound. Substrates in general are sufficiently thicker than the semiconductor layers, which are typically formed by an epitaxial growth technique. This accordingly means that by providing the first electroconductive semiconductor layer, active layer, and second electroconductive semiconductor layer on a substrate, electric current supplied to the layers will diffuse throughout the substrate and therefore band #1 light generated in the active layer will spread along the plane of the active layer (that is, heading toward the side faces of the semiconductor laminate). Pursuant to this light-emitting diode, band #1 light can consequently be taken out from the side face of the semiconductor laminate more efficiently.

The light-emitting diode may be further characterized in that the phosphor is a phosphorescent sheet glued to the side face of the semiconductor laminate. Inasmuch as the thickness of the phosphorescent sheet can be easily adjusted, furnishing the light-emitting diode with the phosphorescent sheet as the phosphor allows an emission spectrum in which mottling is minimized to be readily produced.

A second light-emitting diode according to the present invention is characterized in being furnished with: (5) a semiconductor laminate composed of nitride semiconductors, and having a first electroconductive semiconductor layer, a second electroconductive semiconductor layer, and an active layer, provided in between the first electroconductive semiconductor layer and the second electroconductive semiconductor layer, for emitting light in a first band of wavelengths; (6) a first optically reflective layer provided on a surface {of the laminate} opposite the surface of the first electroconductive semiconductor layer that faces onto the active layer; and (7) a second optically reflective layer provided on a surface {of the laminate} opposite the surface of the second electroconductive semiconductor layer that faces onto the active layer; and is characterized in that the semiconductor laminate further includes a substrate made of a GaN-based compound, situated in between the first electroconductive semiconductor layer and the first optically reflective layer, and in that the substrate contains a luminescent source for receiving light of the first wavelength band and emitting light in a second band of wavelengths.

In the above-described second light-emitting diode, inasmuch as the semiconductor laminate includes the substrate containing the luminescent source, the substrate luminescent source is partially pumped by the band #1 light output from the active layer, which generates band #2 light within the substrate. This thus means that rays of light in both bands #1 and #2 are reflected at the first and second reflective layers, mix together with each other, and are emitted from the side face of the semiconductor laminate. An emission spectrum that is tuned depending on the band #1 light and the band #2 light is thus produced. Pursuant to a second light-emitting diode as set forth above, because rays of band #1 light from the active layer and rays of band #2 light generated inside the substrate are gathered on the side face of the semiconductor laminate, the optical intensity of the rays in band #1 and that of the rays in band #2, emitted from the side face of the semiconductor laminate, can readily be made to conform with each other. An emission spectrum in which unevenness of hue is minimized can accordingly be achieved.

The light-emitting diode may be further characterized in being additionally furnished with an optically reflective film provided on a side face among the plural side faces of the semiconductor laminate excepting its light-emitting face. This makes it possible to gather band #1 light (and band #2 light) onto a specified side face (light-emitting face) among the side faces of the semiconductor laminate, thereby restricting the emitting direction of the light and contributing to enhancing the efficiency with which the light is taken out.

In addition, a first semiconductor light-emitting device according to the present invention is characterized in that a plurality of any of the light-emitting diodes described above is arranged stacked in the laminating orientation. The semiconductor light-emitting device enables light of comparatively large luminous energy to be produced, and the configuration enables the device to be scaled down comparatively.

Furthermore, a second semiconductor light-emitting device according to the present invention is a semiconductor light-emitting device equipped with at least one of any of the light-emitting diodes described above, and is characterized in being further furnished with a rectangular light guide having a light-extraction surface; an optically reflective surface, on the side of the guide opposite the light-extraction surface, for reflecting light in the first and second bands of wavelengths; and a side surface that intersects with the orientation in which the light-extraction surface extends and the orientation in which the reflective surface extends. The device is therein characterized in that the light-emitting diode is mounted on the light guide so that the side face of the semiconductor laminate and the side face of the light guide oppose each other. Since light from the side face of the semiconductor laminate in the light-emitting diode is presented to the side face of the light guide, the thickness of the light guide may be the same as the thickness of the semiconductor laminate. Accordingly, the light guide can be made thinner compared with conventional backlights and similar light-emitting devices. And the fact that as the light-emitting diode, the second semiconductor light-emitting device is equipped with any of the light-emitting diodes described above enables light in which unevenness of hue in the emission spectrum is minimized to be emitted from the light-extraction surface.

In accordance with the present invention, by means of a light-emitting diode as well as a semiconductor light-emitting device an emission spectrum in which unevenness of hue is minimized can be achieved.

From the following detailed description in conjunction with the accompanying drawings, the foregoing and other objects, features, aspects and advantages of the present invention will become readily apparent to those skilled in the art.

### BRIEF DESCRIPTION OF THE DRAWINGS

Fig. 1 is a partially cut-away oblique view illustrating a first embodiment of a light-emitting diode according to the present invention;
Fig. 2 is a sectional view illustrating the configuration of an active layer in the first embodiment;
Figs. 3 through 6 are diagrams for explaining a method of manufacturing a light-emitting diode;
Fig. 7A is an oblique view illustrating a light-emitting diode according to the first embodiment, while Fig. 7B is an oblique view illustrating a light-emitting diode according to a modified example of the first embodiment;
Fig. 8 is a partially cut-away oblique view illustrating a second embodiment of a light-emitting diode according to the present invention;
Fig. 9A is an oblique view illustrating a light-emitting diode according to the second embodiment, while Fig. 9B is an oblique view illustrating a light-emitting diode according to a modified example of the second embodiment;
Figs. 10A and 10B are sectional views illustrating a semiconductor light-emitting device according to the present invention in a third embodiment;
Fig. 11 is an oblique view illustrating a semiconductor light-emitting device according to the present invention in a fourth embodiment;
Fig. 12A is a sectional view illustrating an I-I section through the semiconductor light-emitting device depicted in Fig. 11, while Fig. 12B is a sectional view showing a conventional backlight for comparison; and
Figs. 13A and 13B are sectional views illustrating an example of a white-light LED.

### DETAILED DESCRIPTION OF THE INVENTION

In the following a detailed explanation of embodiments of a light-emitting diode as well as a semiconductor light-emitting device according to the present invention will be made while referring to the accompany drawings. It should be understood that in explaining the drawings, identical elements are labeled with identical reference marks, and redundant explanation will be omitted.

### Embodiment 1

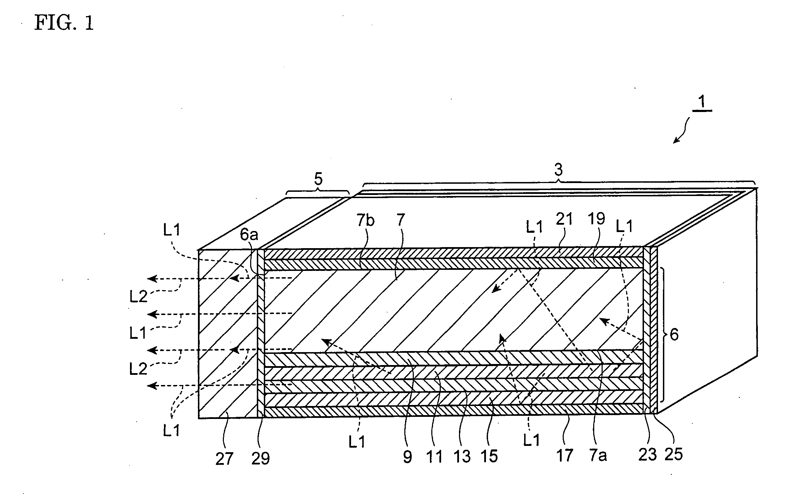

Fig. 1 is an oblique diagram illustrating an LED (light-emitting diode) according to the Embodiment 1 of the present invention. With reference to Fig. 1, the LED 1 of the present invention is composed of a light-emitting section 3 and a phosphorescent section 5 attached to a side surface of the light-emitting section 3. The light-emitting section 3 includes a semiconductor laminate 6, an optically reflective layer 19 (first reflective layer) provided on the semiconductor laminate 6, a cathode electrode 21 provided on the reflective layer 19, an optically reflective layer 17 (second reflective layer) provided on the surface of the semiconductor laminate 6 opposite the reflective layer 19, an insulating layer 23 provided on a side surface of the semiconductor laminate 6, and a reflective film 25 provided on the insulating layer 23.

The laminate 6 is composed of a substrate 7, an n-type cladding layer 9 laminated onto the substrate 7 and serving as a first conductive semiconductor layer, an active layer 11 provided on the n-type cladding layer 9, and a p-type cladding layer 13 and a p-type contact layer 15 successively laminated onto the active layer 11 and each serving as a second conductive semiconductor layer.

The substrate 7 is made of a conductive GaN-based compound, and in the present embodiment, the substrate 7 is composed of GaN. The substrate 7 allows light *L1* generated in the active layer 11 to be transmitted through it, and has a resistivity of, for example, not more than 0.5 Ωcm, a thickness of, for example, 100 µm to 200 µm. In planar dimension the substrate 7 is, for example, a rectangle 0.5 mm to 30 mm to a side.

The n-type cladding layer 9 is composed of a nitride semiconductor doped with n-type impurities. For example, in the present embodiment, the n-type cladding layer 9 is composed of Al_{X1}Ga_{1-X1}N (0 ≤ X1 < 1) doped with Si, and is formed on a principal surface 7a of the substrate 7.

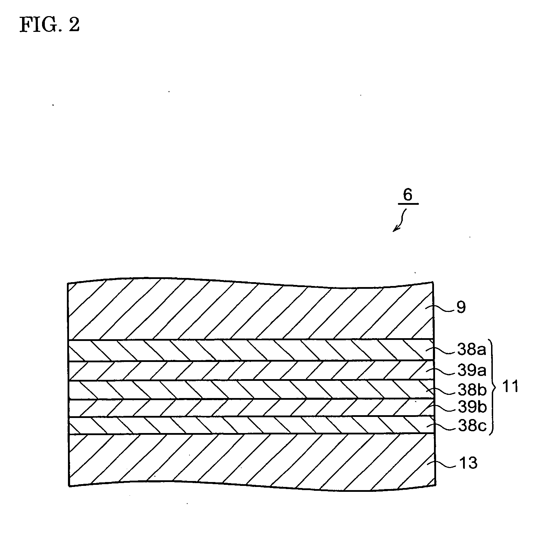

Carriers are introduced to the active layer 11 to generate the light *L1* in a first band of wavelengths. In accordance with the present embodiment, the first band of wavelengths is that of, for example, blue light (420 nm to 490 nm). The active layer 11 is formed on the n-type cladding layer 9 and has a multiple quantum well structure. Fig. 2 is a cross-sectional view illustrating the structure of the active layer 11 according to the present embodiment. With reference to Fig. 2, the active layer 11 includes barrier layers 38a-38c and well layers 39a and 39b. More specifically, the active layer 11 is formed by sequentially laminating the barrier layer 38a, the well layer 39a, the barrier layer 38b, the well layer 39b and the barrier layer 38c.

The barrier layers 38a-38c and the well layers 39a and 39b are made of a GaN-based semiconductor represented by a chemical equation such as Al_{X2}In_{Y2}Ga_{1-X2-Y2}N (0 ≤ X2 < 1; 0 ≤ Y2 < 1; 0 ≤ X2 + Y2 < 1). In accordance with the present embodiment, the compositions of the barrier layers 38a-38c are represented by the above equation with 0 < X2 < 1 and Y2 = 0, while the compositions of the well layers 39a and 39b are represented by the same equation with 0 < X2 < 1 and 0 < Y2 < 1. In addition, the compositions of the barrier layers 38a-38c and the well layers 39a and 39b are adjusted so that the band gaps of the barrier layers 38a-38c will be larger than those of the well layers 39a and 39b. This configuration traps carriers introduced into the active layer 11 in the well layers 39a and 39b.

With reference to Fig. 1, the p-type cladding layer 13 is composed of a nitride semiconductor doped with p-type impurities. For example, in the present embodiment, the p-type cladding layer 13 is composed of Al_{X1}Ga_{1-X1}N (0 ≤ X1 < 1) doped with Mg. The p-type cladding layer 13 is formed on the active layer 11, so that the active layer 11 is interposed between the n-type cladding layer 9 and the p-type cladding layer 13.

The p-type contact layer 15 is provided to electrically connect the p-type cladding layer 13 and an anode electrode (described below), and is composed of a nitride semiconductor doped with p-type impurities. For example, in the present embodiment, the p-type contact layer 15 is composed of GaN doped with Mg. The p-type contact layer 15 is formed on the p-type cladding layer 13.

The reflective layer 17 is provided on a side of the p-type contact layer 15 opposite the side on which the active layer 11 is provided. It is preferable that the reflective layer 17 is provided on the entire surface of the p-type contact layer 15. The reflective layer 17 is made of, for example, a metal such as Ag or Al, and reflects the light *L1* generated in the active layer 11. Although the anode is integrated with the reflective layer 17 in the present embodiment, the anode can also be provided separately. In addition, the reflective layer 17 and the p-type contact layer 15 can be in ohmic contact.

The reflective layer 19 is provided on a side of the n-type cladding layer 9 opposite the side on which the active layer is provided. It is preferable that the reflective layer 19 is provided on the entire surface of the n-type cladding layer 9. In accordance with the present embodiment, since the semiconductor laminate 6 includes the substrate 7, the reflective layer 19 is provided on the rear surface 7b of the substrate 7. Similar to the reflective layer 17, the reflective layer 19 is also made of, for example, a metal such as Ag or Al, and reflects the light *L1* generated in the active layer 11. Although the reflective layer 19 is provided separately from the cathode in the present embodiment, the reflective layer 19 can also be integrated with the cathode. In addition, the reflective layer 19 and the substrate 7 can be in ohmic contact.

The reflective film 25 is provided on a side of the semiconductor laminate 6 excepting side with a light-emitting surface 6a, and the insulating layer 23 is interposed between the semiconductor laminate 6 and the reflective film 25. In accordance with the present embodiment, the optically reflective film 25 and the insulating layer 23 are provided on three of the four side surfaces of the semiconductor laminate 6, and the side surface on which no optically reflective film 25 is provided serves as the light-emitting surface 6a. The reflective film 25 is isolated from the semiconductor laminate 6, the reflective layers 17 and 19, and the cathode electrode 21 by the insulating layer 23. Similar to the reflective layers 17 and 19, the reflective film 25 is also made of, for example, a metal such as Ag or Al, and reflects the light *L1* generated from the active layer 11.

The phosphorescent section 5 includes a phosphorescent plate 27 and an adhesive layer 29. The phosphorescent plate 27 is molded from a phosphor in solid form that receives the light *L1* and subsequently generates light *L2* in a second band of wavelengths longer than that of the light *L1.* In accordance with the present embodiment, the second band of wavelengths is that of, for example, yellow light (500 nm to 700 nm), and the phosphor is, for example, ZnSSe. The phosphorescent plate 27 is glued to the side surface of the semiconductor laminate 6 by the adhesive layer 29. In accordance with the present embodiment, the phosphorescent plate 27 is provided on the one surface, out of the four surfaces, on which no optically reflective film 25 is provided (in other words, the light-emitting surface 6a). It will be appreciated that the thickness of phosphorescent plate 27 along the direction intersecting with the side surface of the semiconductor laminate 6 is adjusted so that the luminous energy of the luminescence (yellow light) *L2* generated in the phosphorescent plate 27, will by means of that yellow light *L2* and blue light *L1* turn into white light of a desired hue.

The operation of an LED 1 having the above described configuration is as follows. When a drive voltage is applied from the exterior of the LED 1 to a region between the cathode electrode 21 and the reflective layer 17, which serves also as the anode electrode, an electric field is generated between the cathode electrode 21 and the reflective layer 17, and carriers are concentrated in the well layers 39a and 39b within the active layer 11. Accordingly, blue light *L1* is generated in the active layer 11 and concentrated on the light-emitting surface 6a after being reflected by the reflective layers 17 and 19 and the reflective film 25. A portion of the blue light *L1* pumps the phosphorescent plate 27 and turns into yellow light *L2*, while the rest transmits through the phosphorescent plate 27 as blue light. As a result, the generated blue light *L1* and yellow light *L2* combine to become white light that is emitted to the exterior from the LED 1.

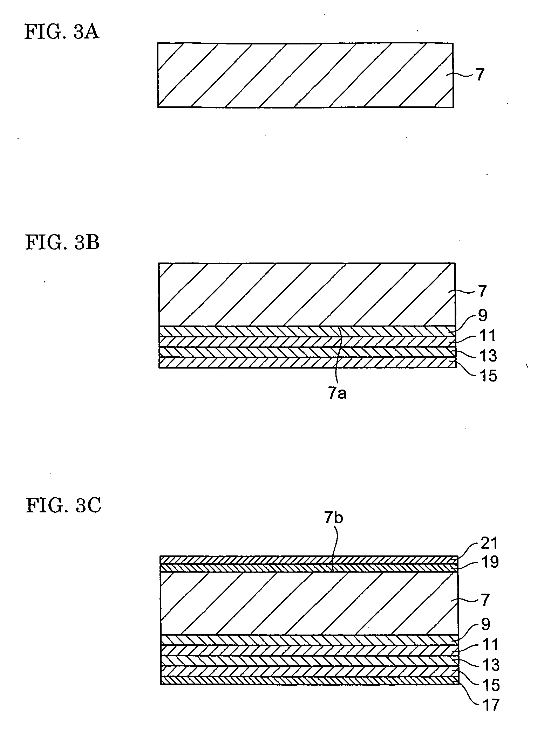

Next, with reference to Figs. 3 through 6, a method for fabricating the LED 1 according to the present embodiment will be described.

Firstly, the wafer-shaped substrate 7 made of conductive GaN is prepared as shown in Fig. 3A. Next, as shown in Fig. 3B, the n-type cladding layer 9, the active layer 11, the p-type cladding layer 13 and the p-type contact layer 15 are epitaxially grown in order onto the principal surface 7a of the wafer-shaped substrate 7. Thereafter, as shown in Fig. 3C, the reflective layer 17 is formed on the p-type contact layer 15 by a process such as vapor deposition, while the reflective layer 19 and the cathode electrode 21 are formed in order on the back side 7b of the substrate 7 by vapor deposition or a like process.

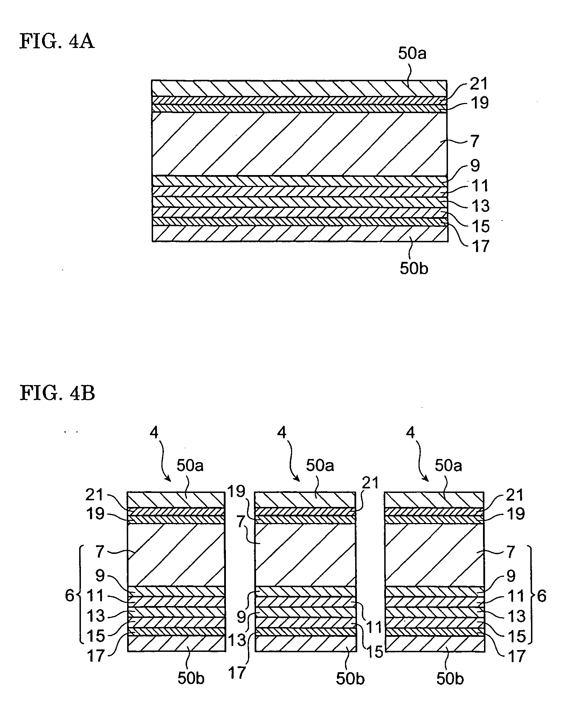

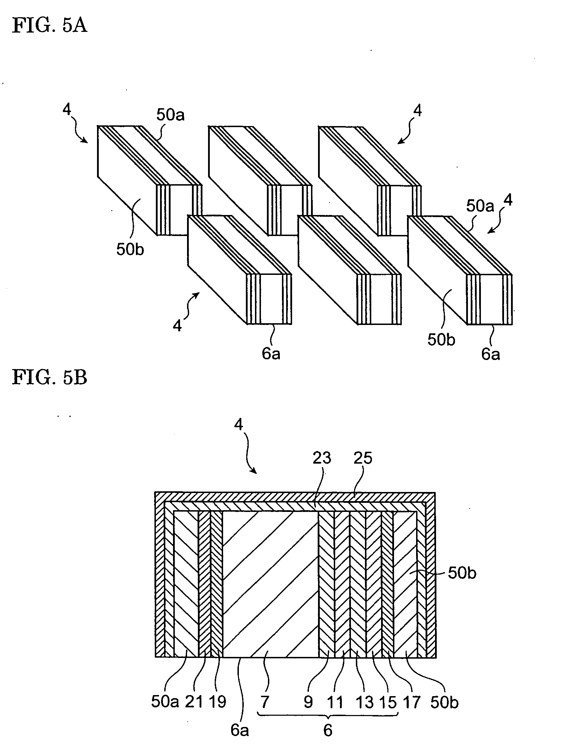

Next, resists 50a and 50b are respectively deposited on the cathode electrode 21 and the reflective layer 17 as shown in Fig. 4A. In Fig. 4B, the wafer-shaped substrate 7 and the respective layers are cut along the thickness direction to obtain chips 4 of a predetermined size. At this point, the semiconductor laminate 6, which includes the substrate 7, the n-type cladding layer 9, the active layer 11, the p-type cladding layer 13 and the p-type contact layer 15, has been formed. As shown in Fig. 5A, each chip 4 is then arranged with a side surface facing down, and the insulating layer 23 and the reflective film 25 are formed in order on the exposed surface of each chip 4 by a process such as sputtering or vapor deposition. Thus the insulating layer 23 and the reflective film 25 are formed on all but one of the side surfaces of each chip 4, as shown in Fig. 5B.

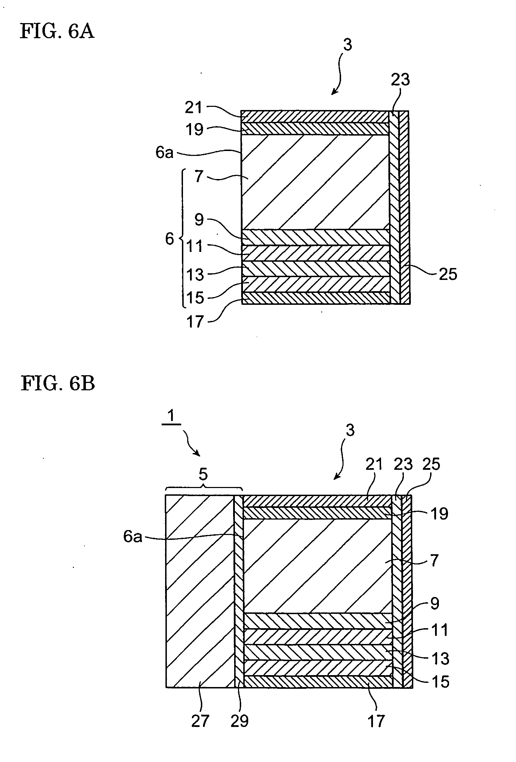

Subsequently the resists 50a and 50b as represented in Fig. 6A are removed. This eliminates the insulating layer 23 and the reflective film 25 where they had been formed on the cathode electrode 21 and the reflective layer 17, meaning that that the insulating layer 23 and the reflective film 25 remain formed only on three side surfaces of the semiconductor laminate 6. Accordingly, the light-emitting section 3 is completed. Subsequently, as shown in Fig. 6B, the adhesive layer 29 is spread on the side surface of the semiconductor laminate 6 on which neither the insulating layer 23 nor the reflective film 25 is provided, and the phosphorescent plate 27 is glued on through the top of the adhesive layer 29, thereby forming the phosphorescent section 5 and completing the LED 1.

In accordance with the present embodiment described above, the LED 1 has the following effects. Firstly, since the blue light *L1* from the active layer 11 is concentrated on the side surface of the semiconductor laminate 6 and the phosphorescent plate 27 is also provided on the side surface thereof, the intensities of the yellow light *L2* and blue light *L1* can be easily matched by adjusting the thickness of the phosphorescent plate 27 accordingly, thereby creating white light with a stabilized hue.

Furthermore, it is preferable that the semiconductor laminate 6 in the LED 1 includes the substrate 7, which is provided between the n-type cladding layer 9 and the reflective layer 19, as described in the present embodiment. The substrate 7 is sufficiently thicker than a semiconductor layer formed by, for example, epitaxial growth. Thus, owing to the n-type cladding layer 9, the active layer 11, and the p-type cladding layer 13 being provided on the substrate 7, current supplied to the layers diffuses within the substrate 7, thereby causing the portion of the active layer 11 that generates blue light *L1* to spread in an orientation that intersects with the lamination orientation of the active layer 11 (in other words, towards the sides of the semiconductor laminate 6). As a result, the LED 1 enables blue light *L1* to be more efficiently extracted from the side surface of the semiconductor laminate 6.

It is also preferable that the LED 1 be furnished with the phosphorescent plate 27 that serves as a phosphor as described in the present embodiment. Inasmuch as the intensity of the yellow light *L2* can be easily regulated by adjusting the thickness of the phosphorescent plate 27, by means of an LED 1 according to the present embodiment white light in which mottling is minimized can be readily produced.

As described in the present embodiment, it is preferable that the reflective film 25 is provided on three of the four side surfaces of the semiconductor laminate 6 in the LED 1. By doing so, blue light *L1* can be concentrated on one specific side surface of the semiconductor laminate 6, thereby restricting the direction in which the white light is emitted and contributing to enhancing the efficiency with which the light is taken out.

In addition, because the LED 1 according to the present embodiment differs from the conventional surface-emitting type of LED in that light is extracted from a side face, a plurality of the LEDs 1 can be stacked while retaining a relatively small dimension. Therefore, providing a plurality of the LEDs 1 to generate a desired light intensity is a simple matter. Moreover, the LED 1 according to the present embodiment utilizes a solid phosphor (phosphorescent plate 27) instead of the phosphor-intermixed synthetic polymer used in conventional LEDs, and therefore the phosphor can be easily mounted on the semiconductor laminate 6, which improves productivity and yields of the LED 1.

### Modified Example

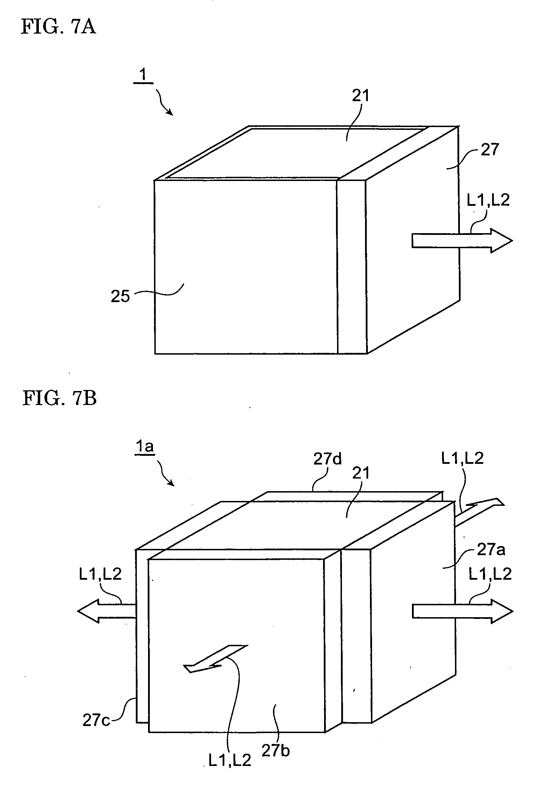

Figs. 7A and 7B are diagrams that depict a modified example of Embodiment 1 described above. Fig. 7A is an oblique diagram illustrating the LED 1 according to the Embodiment 1, while Fig. 7B is an oblique perspective diagram illustrating an LED 1a according to the modified example. According to the present invention, the LED can have a configuration in which the phosphorescent plate 27 is provided on one of the four side surfaces of the semiconductor laminate 6, as in the LED 1 shown in Fig. 7A, or a configuration in which the phosphorescent plate 27 is provided on all four side surfaces of the semiconductor laminate 6, as in the LED 1a shown in Fig. 7B. In the later case, no reflective film will be provided on the side surface. Thus, according to the alternative embodiment of the Embodiment 1, the phosphorescent plate 27 can be provided on more than one side surface of the semiconductor laminated part, and such side surfaces will serve as light-emitting surfaces.

### Embodiment 2

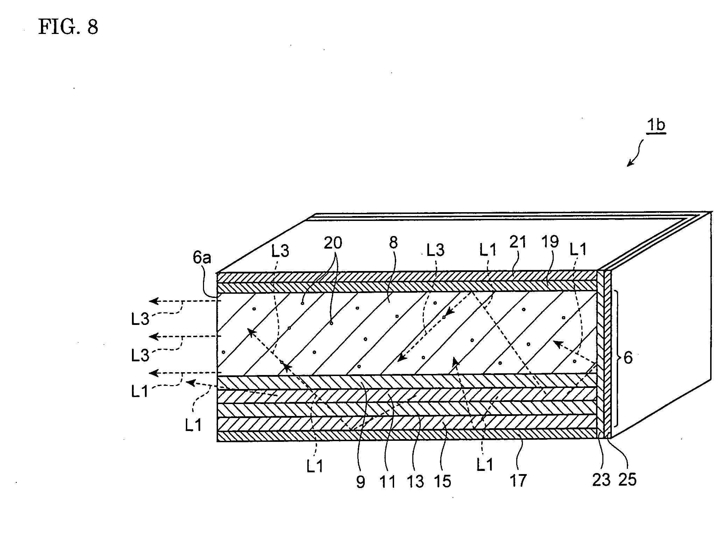

Fig. 8 is an oblique diagram illustrating an LED 1b according to the Embodiment 2 of the present invention. The LED 1b is different from the LED 1 in that (1) the LED 1b does not include the phosphorescent plate 27 and the adhesive layer 29 but (2) has a substrate 8 that includes luminescent sources 20. Description of the other features of the LED 1b will be omitted since they are the same as those of the LED 1.

The substrate 8 is made of a conductive GaN-based compound. In addition, the substrate 8 includes the luminescent sources 20 that receives light (blue light *L1*) in a first band of wavelengths and generates light (yellow light *L3*) in a second band of wavelengths. In growing the GaN substrate 8 by a process such as vapor phase epitaxy, impurities such as oxygen and carbon can be added or crystal defects (nitrogen holes) introduced into the substrate. The impurities such as oxygen and carbon, or crystal defects such as nitrogen holes serve as the luminescent sources 20, receiving blue light *L1* and generating luminescence (yellow light *L3*). For example, when irradiated with light having a wavelength shorter than 480nm, the luminescent sources 20 generate luminescence with a wide wavelength range of 520 nm to 650 nm. The central wavelength and emission spectrum of the luminescence are controlled by the types and quantity of impurities added or the quantity of crystal defects.

Besides the luminescent sources 20, the substrate 8 in the LED 1b also includes the semiconductor laminate 6, such that a portion of the blue light *L1* output from the active layer 11 pumps the luminescent sources 20 in the substrate 8 to generate yellow light *L3* within the substrate 8. Blue light *L1* and yellow light *L3* are then reflected by the reflective layers 17 and 19 and the reflective film 25 and mix together with each other to generate white light, which in turn is emitted from the light-emitting surface 6a that is a side surface of the semiconductor laminate 6.

According to the present embodiment, blue light *L1* emitted from the active layer 11 and yellow light *L3* generated within the substrate 8 are concentrated at the side surface (light-emitting surface 6a) of the semiconductor laminate 6, so that the intensities of the blue light rays *L1* and the yellow light rays *L2* emitted from the side surface of the semiconductor laminate 6 can readily be made to conform with each other. As a result, white light in which mottling is kept under control can be emitted from the LED 1b.

### Modified Example

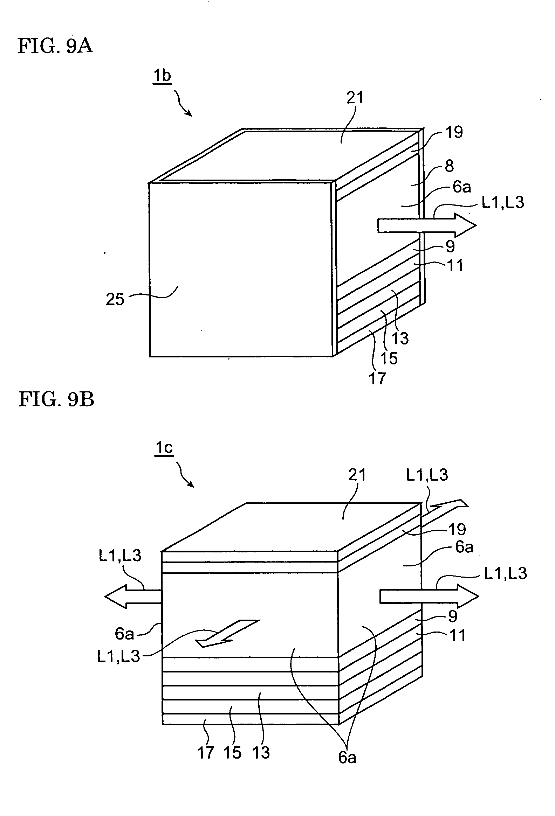

Figs. 9A and 9B are diagrams that depict a modified example of Embodiment 2 described above. Fig. 9A is an oblique diagram illustrating the LED 1b according to the Embodiment 2, while Fig. 9B is an oblique diagram illustrating an LED 1c according to the modified example. According to the present invention, the LED can have a configuration in which the reflective film 25 is provided on three of the four side surfaces of the semiconductor laminate 6, such as the LED 1b shown in Fig. 9A, or a configuration in which no reflective film 25 is provided, as in the LED 1c shown in Fig. 9B. Therefore, the reflective film 25 can be provided on a side surface of choice among the side surfaces of the semiconductor laminate, and a side surface apart from that can be made the light-emitting surface 6a.

### Embodiment 3

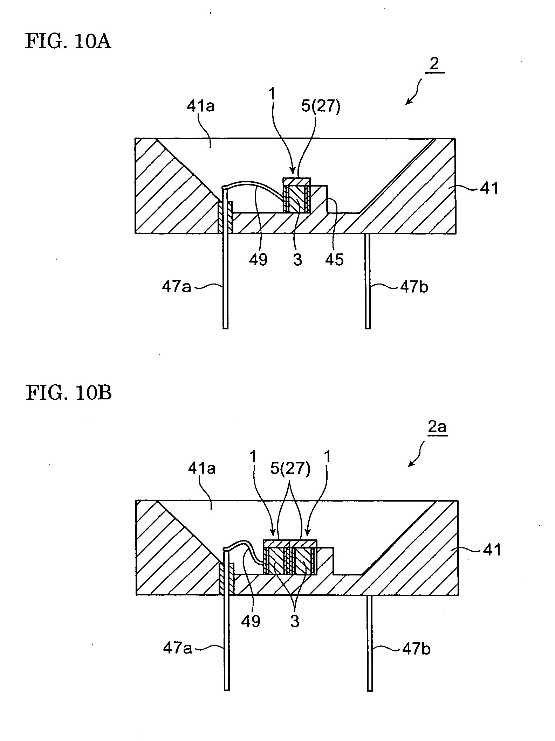

Figs. 10A and 10B are cross-sectional views illustrating semiconductor light-emitting devices according to Embodiment 3 of the present invention. With reference to Fig. 10A, a semiconductor light-emitting device 2 includes the LED 1 of the Embodiment 1, a case 41, and lead pins 47a and 47b. The LED 1 is loaded into a cavity 41a in the case 41. The LED 1 is carried with its side surface opposite the side surface (light-emitting surface) having the phosphorescent plate 27 facing the bottom surface of the groove 41a. The groove 41a is later filled with a transparent synthetic polymer to protect the LED 1.

Furthermore, a protrusion 45 formed integrally with the case 41 is provided on the bottom of the groove 41a, and the LED 1 is positioned so that either the cathode electrode 21 or the anode electrode (light-emitting layer 17, cf. Fig. 1 for both electrodes) is in contact with a side surface of the protrusion 45. The case 41 is electrically connected to the lead pin 47b, such that one of the electrodes of the LED 1 is electrically connected to the lead pin 47b, while the other electrode is electrically connected to the lead pin 47a by a wire 49. The lead pin 47a is fixed to the case 41 by an insulating material.

Fig. 10B depicts another semiconductor light-emitting device 2a according to the present embodiment. The semiconductor light-emitting device 2a is different from the semiconductor light-emitting device 2 in that the semiconductor light-emitting device 2a includes a plurality of LEDs 1. According to the present embodiment, the semiconductor light-emitting device 2a includes two LEDs 1, and both are loaded within the groove 41a of the case 41 with the sides opposite the light-emitting surfaces facing the bottom surface of the groove 41a. In other words, the two LEDs 1 are carried so that the orientation in which their active layer extends intersects with the bottom surface of the groove 41a. The two LEDs 1 are arranged stacked along the thickness direction with their respective electrodes connected in series as a mechanism whereby a drive voltage is applied through the lead pins 47a and 47b.

In both the semiconductor light-emitting device 2 and the semiconductor light-emitting device 2a, drive voltage applied from the exterior of the semiconductor light-emitting device through the lead pins 47a and 47b is directed to a region between the anode electrode (light-emitting layer 17) and the cathode electrode 21 of the LED(s) 1. Accordingly, as described in Embodiment 1, white light generated by means of blue light and yellow light is emitted from one side surface of the LED 1, that is, the semiconductor laminate 6 side on which the phosphorescent plate 27 is provided. The white light is emitted heading towards the exterior of the semiconductor light-emitting device 2 (or 2a).

According to the present embodiment, since both semiconductor light-emitting devices 2 and 2a include the LED 1 described in the Embodiment 1, white light with a stabilized hue can be emitted from the semiconductor light-emitting devices. Moreover, white light having a relatively large intensity can also be easily obtained since the semiconductor light-emitting device 2a includes a plurality of LEDs 1. Furthermore, since the LEDs 1 are configured so that light is emitted from the side face, the LEDs 1 can be stacked along the thickness direction, which allows the semiconductor light-emitting device to be fabricated in a relatively small size even though the device is furnished with a plurality of LEDs 1.

### Embodiment 4

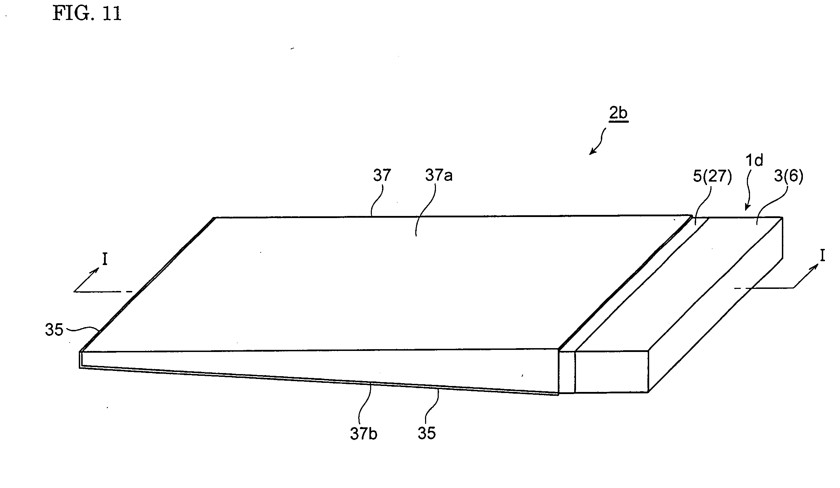

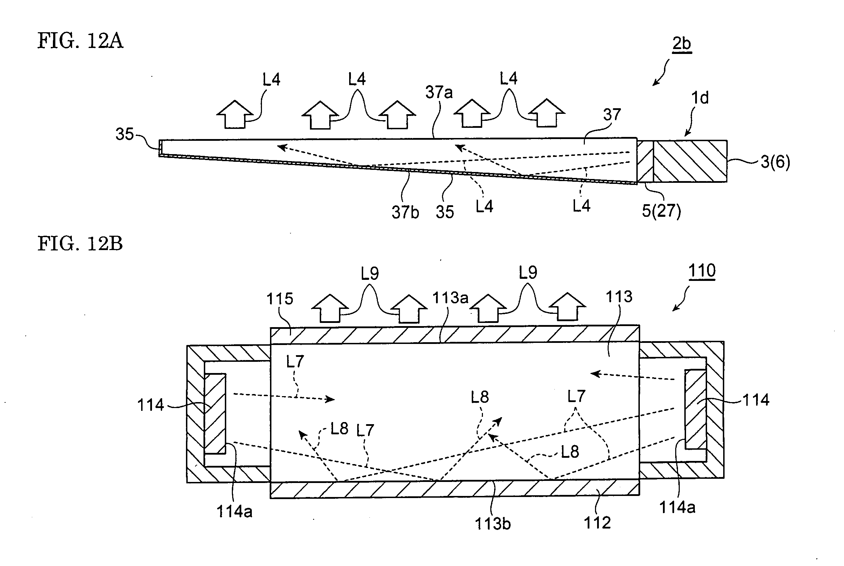

Fig. 11 is an oblique diagram illustrating a semiconductor light-emitting device 2b according to the Embodiment 4 of the present invention. Fig. 12A is a cross-sectional view illustrating an I-I cross section of the semiconductor light-emitting device 2b shown in Fig. 11. The semiconductor light-emitting device 2b serves as a backlight for liquid crystal displays (LCDs) and the like. As shown in Figs. 11 and 12A, the semiconductor light-emitting device 2b includes an LED 1d and a rectangular light guide 37. The LED 1d has the same configuration as the LED 1 described in the Embodiment 1, and the light-emitting section 3 has a rectangular planar form with a dimension of, for example, 0.5 mm X 30 mm. The phosphorescent plate 27 in the LED 1d is provided on a longitudinal side surface of the semiconductor laminate 6, and the LED 1d is attached to the light guide 37 so that the longitudinal side surface of the semiconductor laminate 6 opposes a side surface of the light guide 37.

The light guide 37 is a white-light-guiding, surface-emitting component. The light guide 37 is preferably made of a material that diffuses white light, such as acrylic or polycarbonate. The light guide 37 receives white light *L4* from the LED 1d, which is mounted on the side surface of the light guide 37, and subsequently emits the white light *L4* from a principal surface 37a of the guide. In other words, the principal surface 37a serves as a light-emitting surface of the light guide 37. A rear surface 37b opposite the principal surface 37a of the light guide 37 is composed of a metal film 35 made of, for example, Al and reflects the white light *L4*. The rear surface 37b of the light guide 37 serves as a reflective surface that reflects the white light *L4* composed of blue light and yellow light.

The white light *L4* emitted from the LED 1d passes through the interior of the light guide 37, with a portion being reflected at the metal film 35, and reaches the principal surface 37a of the light guide 37. At that moment the white light *L4* is diffused in the light guide 37 interior. Thus, with white light *L4* being emitted approximately uniformly from the principal surface 37a (light-emitting surface) of the light guide 37, the light guide 37 surface-emits.

According to the present embodiment, the semiconductor light-emitting device 2b has the following effects. Firstly, since light from the side surface of the semiconductor laminate 6 in the LED 1d is presented to the side surface of the light guide 37, the light guide 37 may be of the same thickness as that of the semiconductor laminate 6. Thus the thickness of the light guide 37 is reduced as compared to the conventional semiconductor light-emitting device such as a backlight.

Fig. 12B is a cross-sectional view illustrating a conventional backlight for comparison. As shown in Fig. 12B, a conventional backlight 110 includes an light guide 113 and a surface-emitting LED 114. The LED 114 is attached to a side surface of the light guide 113 such that a principal surface 114a serving as the light-emitting surface faces the side surface of the light guide 113. A phosphor 112 is attached to the rear surface 113b of the light guide 113, and yellow light *L8* is generated when a portion of blue light *L7* from the LED 114 is irradiated onto the phosphor 112. A diffusion layer 115 is provided on the principal surface 113a of the light guide 113 so that the blue light *L7* and the yellow light *L8* are diffused within the diffusion layer 115 and thereby generate white light L9.

In the conventional backlight 110 shown in Fig. 12B, the thickness of the light guide 113 is relatively large because the thickness has to correspond to the width of the principal surface 114a, serving as the light-emitting surface, of the LED 114. Moreover, the phosphor 112 is provided on the rear surface of the light guide 113, thus further increasing the thickness of the backlight 110. In recent years, the ongoing miniaturization of electronic devices, such as mobile phones, containing LCDs has increased the need for developing thinner backlights for LCDs. According to the present embodiment, the thickness of the light guide 37 in the semiconductor light-emitting device 2b can be reduced, thus contributing to the miniaturization of devices that include LCDs.

Furthermore, since the semiconductor light-emitting device 2b according to the present embodiment includes the LED 1d, which has the same configuration as the LED 1 described in Embodiment 1, white light *L4* with a stabilized hue can be reflected by the rear surface 37b and emitted from the principal surface 37a (light-emitting surface). Although the present embodiment describes a semiconductor light-emitting device 2b including only one LED 1d, multiple LEDs with a common light-emitting direction can also be attached to the side surface of the light guide 37.

The LEDs and the semiconductor light-emitting devices of the present invention are not limited to the above described embodiments and modified examples, and in addition various modifications are possible. For example, although the LED in each embodiment described above is furnished with a substrate made from a GaN-based compound, the substrate is not limited to that material, and may be made of another electroconductive compound, such as a SiC, AlN, Si, etc.

In addition, the materials used as the reflective layers and the reflective films are also not limited only to metals; other materials such as photonic crystals in which the refractive index is adjusted to reflect light can also be used. Additional reflective films can also be provided on the side surfaces of the phosphorescent plate along the thickness direction, thereby preventing the light from escaping through the side surfaces of the phosphorescent plate, and thus further stabilizing the hue of the white light.

Only selected embodiments have been chosen to illustrate the present invention. To those skilled in the art, however, it will be apparent from the foregoing disclosure that various changes and modifications can be made herein without departing from the scope of the invention as defined in the appended claims. Furthermore, the foregoing description of the embodiments according to the present invention is provided for illustration only, and not for limiting the invention as defined by the appended claims and their equivalents.

## Claims

1. A light-emitting diode (1) furnished with:
a semiconductor laminate (6) composed of nitride semiconductors, and having a first electroconductive semiconductor layer (9), a second electroconductive semiconductor layer (13, 15), and an active layer (11), provided in between said first electroconductive semiconductor layer (9) and said second electroconductive semiconductor layer 13, 15), for emitting light (1) in a first band of wavelengths;
a first optically reflective layer (19) provided on a surface of said laminate (6) opposite the surface of said first electroconductive semiconductor layer (9) that faces onto said active layer (11);
a second optically reflective layer (17) provided on a surface of said laminate (6) opposite the surface of said second electroconductive semiconductor layer (13, 15) that faces onto said active layer (11); and
a phosphor (5), provided on a side face of said semiconductor laminate (6), for receiving light (L1) of the first wavelength band and emitting light (L2) in a second band of wavelengths.

2. A light-emitting diode (1) as set forth in claim 1, wherein said semiconductor laminate (6) is further furnished, in between said first electroconductive semiconductor layer (9) and said first optically reflective layer (19), with a substrate (7) made from a GaN-based compound.

3. A light-emitting diode as set forth in claim 1 or 2, wherein said phosphor is a phosphorescent sheet (27) glued to said side face of said semiconductor laminate (6).

4. A light-emitting diode (1b) furnished with
a semiconductor laminate (6) composed of nitride semiconductors, and having a first electroconductive semiconductor layer (9), a second electroconductive semiconductor layer (13, 15), and an active layer (11), provided in between said first electroconductive semiconductor layer (9) and said second electroconductive semiconductor layer (13, 15), for emitting light (L1) in a first band of wavelengths;
a first optically reflective layer (19) provided on a surface of said laminate (6) opposite the surface of said first electroconductive semiconductor layer (9) that faces onto said active layer (11); and
a second optically reflective layer (17) provided on a surface of said laminate (6) opposite the surface of said second eleetroconductive semiconductor layer that faces onto said active layer; wherein
said semiconductor laminate (6) further includes a substrate (8) made of a GaN-based compound, situated in between said first electroconductive semiconductor layer (9) and said first optically reflective layer (19), and
said substrate (8) contains a luminescent source (20) for receiving light (L1) of the first wavelength band and emitting light (L3) in a second band of wavelengths.

5. A light-emitting diode (1, 1b) as set forth in any of claims 1 through 4, further furnished with an optically reflective film (25) provided on a side face among the plural side faces of said semiconductor laminate (6) excepting its light-emitting face (6a).

6. A semiconductor light-emitting device (2a) **characterized in that** a plurality of the light-emitting diodes (1, 1b) as set forth in any of claims 1 through 5 is arranged stacked in the laminating orientation.

7. A semiconductor light-emitting device (2b) equipped with at least one of any of the light-emitting diodes (1, 1b, 1 d) as set forth in any of claims 1 through 5, the semiconductor light-emitting device (1,1b) being further furnished with
a rectangular light guide (37) having a light-extraction surface (37a), an optically reflective surface (37b), on the side of the guide opposite the light-extraction surface (37a), for reflecting light in the first and second bands of wavelengths, and a side surface that intersects with the orientation in which the light-extraction surface (37a) extends and the orientation in which the reflective surface extends (37b); wherein
said light-emitting diode (1, 1b, 1d) is mounted on said light guide (37) so that said side face of said semiconductor laminate (6) and said side face of said light guide (37) oppose each other.
